# EUROPÄISCHE PATENTSCHRIFT

(11) **EP 0 946 971 B1**
(45) Veröffentlichungstag und Bekanntmachung des Hinweises auf die Patenterteilung: **24.07.2002**
(21) Anmeldenummer: 97910406.4
(22) Anmeldetag: 01.10.1997
(51) Int. Cl.: H01L 21/00

(54) **VORRICHTUNG ZUM BEHANDELN VON SUBSTRATEN**
SUBSTRATE TREATMENT DEVICE
DISPOSITIF POUR TRAITER DES SUBSTRATS

(30) Priorität: 04.11.1996 DE 19645425
(43) Veröffentlichungstag der Anmeldung: 06.10.1999
(73) Patentinhaber: STEAG MicroTech GmbH, 72124 Pliezhausen (DE)
(72) Erfinder: WEBER, Martin, D-78073 Bad Dürrheim (DE)
(74) Vertreter: Wagner, Karl H., Dipl.-Ing.
(86) Internationale Anmeldenummer: EP9705408
(87) Internationale Veröffentlichungsnummer: WO9820522

(56) Entgegenhaltungen:
- EP-A- 0 292 090
- US-A- 5 369 891
- PATENT ABSTRACTS OF JAPAN vol. 95, no. 10, 30.November 1995 & JP 07 176509 A (TOKYO ELECTRON LTD), 14.Juli 1995,

## Beschreibung

Die Erfindung betrifft eine Vorrichtung zum Behandeln von Substraten in einem ein Behandlungsfluid enthaltenden Fluid-Behälter, mit wenigstens einer Substrat-Aufnahmeeinrichtung und einer zum Absenken und Anheben der Substrat-Aufnahmeeinrichtung vorgesehenen Hubeinrichtung, die seitlich am Behälter angeordnet ist und von der sich Teile über dem Behälter und über dem Behandlungsfluid befinden.

Vorrichtungen dieser Art sind aus der auf dieselbe Anmelderin zurückgehenden DE 44 13 077 A1 und DE 195 46 990 A1 bekannt und darüberhinaus in den nicht vorveröffentlichten Anmeldungen DE 196 16 402.8, DE 196 37 875.3, DE 195 37 879.2 derselben Anmelderin beschrieben. Die Hubeinrichtung ist dabei seitlich am Fluidbehälter angeordnet. Die Teile der Hubeinrichtung, die die in das Behandlungsfluid eintauchende Substrat-Aufnahmeeinrichtungen haltern, ragen in einen Bereich über dem Becken und über dem Behandlungsfluid hinein. Da das Behandlungsfluid Chemikalien enthält, treten Dämpfe dieser Chemikalien über der Oberfläche des Behandlungsfluids und insbesondere auch im Bereich der Hubeinrichtungen auf. Insbesondere dann, wenn die Hubeinrichtung von einem Gehäuse umgeben ist, sammeln sich diese Dämpfe im Bereich der Hubeinrichtungen und in diesem Gehäuse an.

Die in das Behandlungsfluid eintauchenden Bauelemente der Hubeinrichtung sind mit einem Material, beispielsweise Kunststoff, beschichtet oder ummantelt, das bzw. der den Kontakt der üblicherweise aus Edelstahl oder Aluminium bestehenden Bauelemente der Hubeinrichtung mit dem Behandlungsfluid und den darin enthaltenen Chemikalien verhindert, die Stahl oder Aluminium angreifen. Es ist jedoch nicht möglich, alle Bauelemente der Hubeinrichtung außerhalb des Behandlungsfluids mit einer Schutzschicht zu versehen, beispielsweise an Verbindungsstellen, die eine genaue Montage mit geringen Toleranzen erfordern oder an relativ zueinander beweglichen Bauteilen. Mindestens diese Teile und Flächen der Hubeinrichtung sind daher dem Dampf ausgesetzt und werden von ihm angegriffen. Daher ist die Lebensdauer derartiger Hubeinrichtungen kurz.

Aus den Druckschriften JP 4-157724 A2, JP 4-265519 A2 und JP 6-84876 A2 sind Vorrichtungen bekannt, bei denen wenigstens ein Fluidbehälter vollständig von einem Gehäuse umgeben ist, in das Reinluft von oben eingeblasen und unten oder seitlich abgeführt wird.

Aus den Druckschriften JP 3-258380 A2, JP 7-273079 A2, JP 5-129268 A2 und JP 7-176509 A sind Vorrichtungen bekannt, bei denen Luft- oder Dampfabsaugungen vorgesehen sind.

JP-7-176 509 offenbart eine Vorrichtung gemäß dem Oberbegriff des Anspruchs 1.

Der Erfindung liegt die Aufgabe zugrunde, die eingangs genannte Vorrichtung zum Behandeln von Substraten in der Weise zu verbessern, daß die Hubeinrichtung eine längere Lebensdauer erhält und vor Chemikaliendämpfen geschützt wird.

Die gestellte Aufgabe wurde erfindungsgemäß durch den kennzeichnenden Teil des Anspruchs 1 gelöst. Die Dampfabsaugeinrichtung saugt die auftretenden Dämpfe ab, und zwar in dem Bereich, in dem sich Teile der Hubeinrichtung über dem Behandlungsfluid befinden. Dadurch wird verhindert, daß aggressive Dämpfe die Hubeinrichtung und deren sehr präzise gefertigten und zusammenwirkenden Bau- und Funktionselemente angreifen. Um hinsichtlich der Ausgestaltung der Hubeinrichtung und deren Bauelemente und Funktionsweise Wiederholungen zu vermeiden, wird auf die DE 195 46 990 A1 und die nicht vorveröffentlichte DE 196 37 875 A1 verwiesen.

Gemäß einer bevorzugten Ausführungsform der Erfindung ist die Hubeinrichtung von einem Gehäuse umgeben. Dieses Gehäuse bildet dabei den Absaugbereich für die Dampfabsaug-Einrichtung und umschließt auch diesen zuvor genannten Bereich. Insbesondere bei Verwendung eines Gehäuses ist die Gefahr groß, daß der schädliche Chemikaliendampf nicht nur in das Gehäuse eindringt und dort verbleibt, sondern daß sich der Chemikaliendampf anreichert und dessen Konzentration im Gehäuse noch ansteigt. Dadurch werden die Bauelemente der Hubeinrichtungen innerhalb des Gehäuses noch stärker angegriffen und es wird die Lebensdauer der Hubeinrichtung wird noch kürzer. Dies wird mit den Merkmalen der Erfindung vermieden.

Die Dampfabsaugeinrichtung saugt die Dämpfe über der Oberfläche des Behandlungsfluids, also unmittelbar am Ort des Entstehens dieser Dämpfe ab. Die Absaugung erfolgt dabei in dem genannten Bereich der Hubeinrichtung mehr oder weniger direkt über der Oberfläche, insbesondere also in dem Bereich über der Oberfläche des Behandlungsfluids, in dem sich auch das Gehäuse befindet.

Zur Absaugung ist eine im Bereich der Hubeinrichtung über dem Behandlungsfluid angeordnete Platte vorgesehen, in die ein Absaugkanal der Dampfabsaugeinrichtung über eine Öffnung mündet. Auf diese Weise ist sichergestellt, daß die Dämpfe am Ort des Entstehens, also unmittelbar über der Behandlungsfluid-Oberfläche abgesaugt werden. Da die Platte über der Oberfläche des Behandlungsfluids und vorzugsweise in einem geringen Abstand davon angeordnet ist, bleibt das abzusaugende Volumen gering, was im Hinblick auf die teueren Aufbereitungseinrichtungen und -verfahren für derartige abgesaugte, mit Dämpfen verunreinigte Luft von großem Vorteil ist.

Gemäß einer weiteren sehr vorteilhaften Ausführungsform der Erfindung ist ein Trennelement vorgesehen, das über der Behandlungsfluid-Oberfläche den Raum im Bereich der Hubeinrichtung vom Raum im Bereich der Substratbehandlung trennt. Diese Ausführungsform trägt ebenfalls dazu bei, daß die Dampfabsaugeinrichtung nur ein begrenztes Absaugvolumen absaugen muß und verhindert wird, daß Luft von Bereichen außerhalb des Hubeinrichtungs-Bereichs angesaugt wird und das Absaugvolumen vergrößert.

Das Trennelement ist dabei vorzugsweise ein senkrechter Steg, der von im Bereich der Hubeinrichtung vorgesehenen Platte insbesondere an der dem Inneren des Fluidbehälter zugewandten Seite oder Kante dieser Platte nach unten absteht und in das Behandlungsfluid eintaucht. Auf diese Weise wird ein im Bereich der Hubeinrichtung definiertes, kleines Volumen für die Dampfabsaugung mit der Folge definiert und abgegrenzt, daß das Dampfabsaugvolumen klein bleibt.

Der von der Dampfabsaugeinrichtung abgesaugte Dampf wird vorzugsweise einer Wiederaufbereitungsanlage zugeführt, in der die schädlichen Dämpfe aus der Luft entfernt und unschädlich gemacht werden.

Die Erfindung wird nachstehend anhand von bevorzugten Ausführungsformen unter Hinweis auf die Figuren erläutert. Es zeigen:
- Fig. 1: einen schematischen Querschnitt durch eine Vorrichtung zum Behandeln von Substraten,
- Fig. 2: einen schematischen Teilausschnitt der in Fig. 1 dargestellten Vorrichtung mit dem Bereich der Hubeinrichtung in Aufsicht und
- Fig. 3: einen Querschnitt entlang der in Fig. 2 eingezeichneten Schnittlinie III-III.

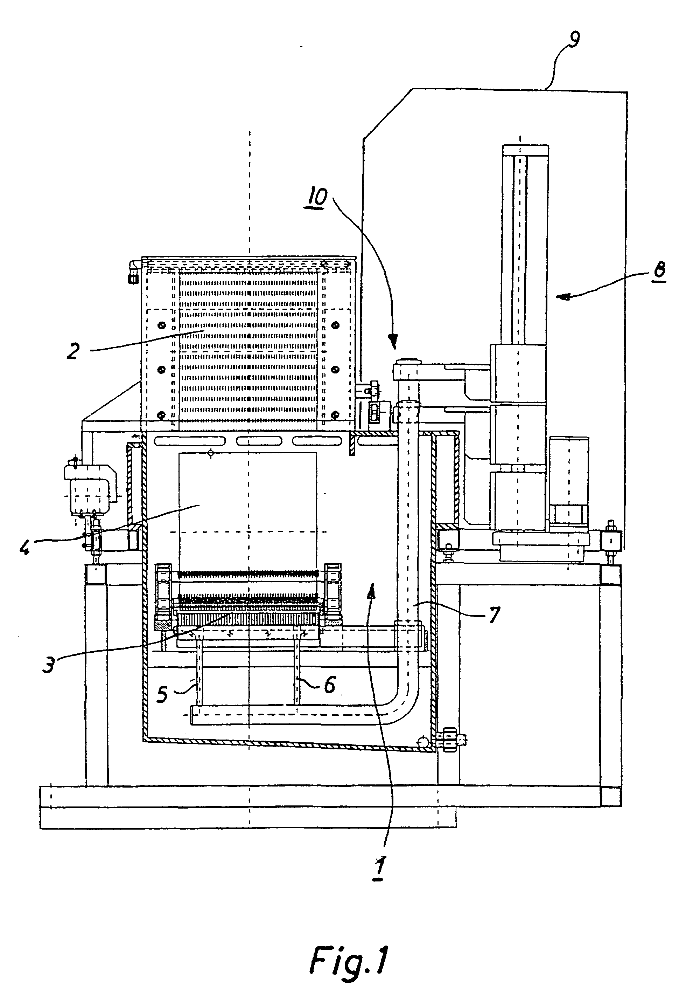

Fig. 1 zeigt im Querschnitt die schematische Darstellung einer Vorrichtung zum Behandeln von Substraten, wie sie etwa in der nicht vorveröffentlichten deutschen Patentanmeldung 196 37 875.3 derselben Anmelderin dargestellt und beschrieben ist. Diejenigen Teile der in Fig. 1 dargestellten Vorrichtung, die für die Beschreibung und Erläuterung der Dampfabsaugeinrichtung erforderlich sind, werden nachfolgend nochmals beschrieben.

Die Vorrichtung gemäß Fig. 1 weist einen Fluidbehälter 1, eine über ihm angeordnete und entfernbare Haube 2, sowie eine Substrat-Aufnahmeeinrichtung 3 zum Haltern eines Substratpakets 4 im Fluidbehälter 1 auf. Die Substrat-Aufnahmeeinrichtung 3 ist über entsprechende Befestigungselemente 5, 6 und über einen Halterungsarm 7 mit einer Hubeinrichtung 8 verbunden, die von einem Gehäuse 9 umgeben ist.

Die in Fig. 1 dargestellte Hubeinrichtung 8 mit Differentialhub ist im einzelnen in der DE 195 46 990 A1 derselben Anmelderin beschrieben, auf die verwiesen wird.

Ein Gehäuse 9 für die Hubeinrichtung 8 steht mit einem Teil über dem Fluidbehälter 1 vor, um auch den Bereich 10 der Hubeinrichtung zu umgeben, der sich über dem Fluidbehälter 1 befindet, an dem die Haltearme 7 befestigt sind.

Das Behandlungsfluid im Fluidbehälter 1 enthält Chemikalien, die an der Oberfläche des Behandlungsfluids als Dämpfe austreten. Beispielsweise enthält ein Reinigungsoder Spülfluid üblicherweise einen geringen Anteil an Salzsäure, die zur Auflösung von noch an den Substraten, beispielsweise an Halbleiter-Wafern anhaftenden Verunreinigungen oder Partikeln dient. In diesem Falle bilden sich über der Fluid-Oberfläche Salzsäuredämpfe. Im Bereich der Haube 2 sind diese Dämpfe nicht kritisch, da sie zusammen mit dem in die Haube 2 eingeleiteten Gas für die Durchführung des Marangoni-Trocknungsverfahrens zusammen mit diesem abgeleitet oder abgesaugt werden. Um hinsichtlich dieser Verfahren und Merkmale Wiederholungen zu vermeiden, wird auf die DE 44 13 077 A1 oder die DE 195 46 990 A1 derselben Anmelderin verwiesen. Auch wenn die Haube 2 nicht vorhanden ist, sind die Chemikaliendämpfe in diesem Bereich nicht kritisch, weil eine derartige Vorrichtung üblicherweise in einem Reinraum steht, in dem eine stetige, laminare Strömung von der Decke zum Boden hin vorhanden ist, die den sich an der Oberfläche des Behandlungsfluids in diesem Bereich bildende Chemikaliendampf abführt.

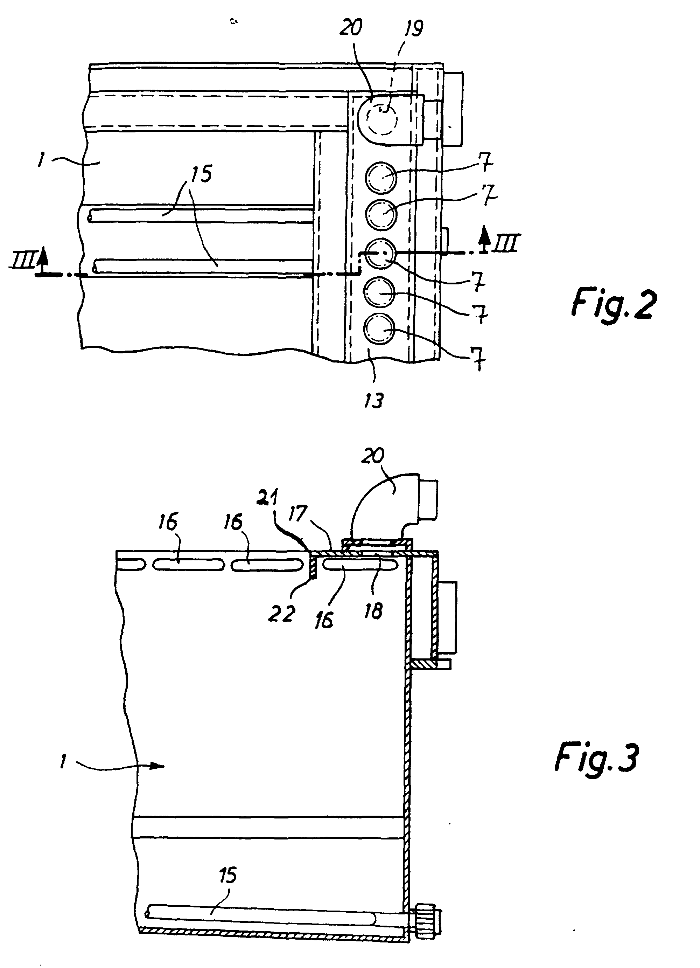

Ganz andere Verhältnisse liegen jedoch im Bereich 10 der Hubeinrichtung über der Oberfläche des Behandlungsfluids vor. Insbesondere dann, wenn die Hubeinrichtung 8 von einem Gehäuse 9 umgeben ist - aber auch ohne das Gehäuse 9 - gelangen diese Dämpfe an die Hubeinrichtung 8 und deren Bauelemente. Während die Halterungsarme 7 und alle im Fluidbehälter 1 befindlichen Bauteile mit einer SchutzBeschichtung gegen aggressive Chemikalien versehen sind, ist dies außerhalb des Fluidbehälters 1 insbesondere für die Bauelemente der Hubeinrichtungen nicht möglich, die sich relativ zueinander bewegen und/oder die Präzisionsbauteile sind und mit geringer Toleranz miteinander verbunden werden müssen. Zur Vermeidung von Wiederholungen wird wiederum auf die DE 195 46 990 A1 verwiesen. Um zu verhindern, daß die teilweise sehr aggressiven Chemikaliendämpfe, beispielsweise Salzsäure-Dampf, an diese vorzugsweise aus Edelstahl oder Aluminium bestehenden Bauelemente der Hubeinrichtung 8, die nicht mit einer Schutzbeschichtung versehen sind oder sein können, gelangen, ist eine Dampfabsaugeinrichtung vorgesehen, die nachfolgend anhand der Fig. 2 und 3 erläutert wird.

In Fig. 2 und 3 ist lediglich der Bereich des Fluidbehälters 1 dargestellt, der einen Fluidbehandlungsbereich und einen Bereich 13 für die Haltearme 7 aufweist. Insbesondere aus Fig. 2 sind die Haltearme 7 und deren Lage im Fluidbehälter 1 ersichtlich. Auch hier wird zur Vermeidung von Wiederholungen wiederum auf die DE 44 13 077 A1 und die DE 195 46 990 A1 verwiesen.

Wie insbesonderes aus Fig. 3 ersichtlich ist, strömt das Behandlungsfluid über ein Einlaßrohr 15 in den Fluidbehälter 1 ein und läuft über Überlaufschlitze 16 an der Oberseite des Fluidbehälters 1 ab.
Im Bereich 13 für die Haltearme 7 ist an der Oberseite des Behälters eine Platte 17 vorgesehen, die als hohle Platte ausgebildet sein kann und eine Öffnung 18 aufweist, in die ein Absaugkanal 19 mündet, der über ein Winkelstück 20 mit einer nicht dargestellten UnterdruckQuelle verbunden ist. Die sich im Bereich der Hubeinrichtung 8 über der Fluidfläche bildenden Dämpfe werden dadurch abgesaugt. Da sich die Platte 17 nur in einem geringen Abstand von der Oberfläche des Behandlungsfluids befindet, ist auch das abzusaugende Luftvolumen mit den darin enthaltenden Chemikaliendämpfen gering.

An der langen, dem Inneren des Fluidbehälters 1 zugewandten Seite oder Kante 21 der Platte 17 steht ein Trennelement 22 in Form eines Steges von der Platte 17 nach unten ab und ragt in das Behandlungsfluid ein. Dadurch wird der Raum über der Fluidoberfläche im Bereich der Hubeinrichtung 8 bzw. des Gehäuses 9 zwischen der Platte 17 und der Fluidoberfläche auch seitlich abgegrenzt, so daß keine Luft von anderen Bereichen der Fluidoberfläche angesaugt wird und das Absaugvolumen auch dadurch klein und in Grenzen gehalten wird.

Die Erfindung wurde zuvor anhand eines bevorzugten Ausführungsbeispiels erläutert. Dem Fachmann sind jedoch zahlreiche Abwandlungen, Ausgestaltungen und Modifikationen möglich, ohne daß dadurch der Erfindungsgedanke verlassen wird. So ist es möglich, nicht nur an einer Stelle, sondern an mehreren Stellen der Absaugplatte 17 einen Absaugkanal 20 vorzusehen. Auch ist die vorliegende Erfindung nicht auf die Ausführungsformen der beschriebenen Substrat-Behandlungsvorrichtungen und Hubeinrichtungen beschränkt.

## Patentansprüche

1. Vorrichtung zum Behandeln von Substraten (4) mit einem ein Behandlungsfluid enthaltenden Fluid-Behälter (1), mit wenigstens einer Substrat-Aufnahmeeinrichtung (3) und einer zum Absenken und Anheben der Substrat-Aufnahmeeinrichtung vorgesehenen Hubeinrichtung (8), die seitlich am Behälter angeordnet ist und von der sich Teile über dem Behälter und über dem Behandlungsfluid befinden, und mit einer Dampfabsaugeinrichtung (17 bis 22) zum Absaugen von Dämpfen in dem Bereich (10), in dem sich Teile der Hubeinrichtung (8) über dem Behandlungsfluid befinden, **dadurch gekennzeichnet, daß** im Bereich (10) über dem Behandlungsfluid eine Platte (17) vorgesehen ist. die eine Öffnung (18) für einen Absaugkanal (19) der Dampfabsaugeinrichtung (17 bis 22) aufweist.

2. Vorrichtung nach Anspruch 1, **dadurch gekennzeichnet, daß** die Hubeinrichtung (8) und deren sich über dem Behandlungsfluid befindenden Teile von einem Gehäuse (9) umgeben sind, das den Bereich (10) für die Dampfabsaugeinrichtung (17 bis 22) umschließt.

3. Vorrichtung nach einem der vorhergehenden Ansprüche, **gekennzeichnet durch** ein Trennelement (22), das den Bereich (10) über der Fluidoberfläche von einem Oberflächenbereich trennt, unter dem die Substratbehandlung stattfindet.

4. Vorrichtung nach Anspruch 3, dadurch gekenneichnet, daß das Trennelement (22) ein senkrechter Steg ist, der von der im Bereich (10) vorgesehenen Platte (17) nach unten absteht und in das Behandlungsfluid eintaucht.

## Claims

1. Device for treating substrates (4), comprising a fluid container (1) containing a treatment fluid, at least one substrate-receiving device (3), a lifting device (8) which is provided for lowering and raising the substrate-receiving device and is arranged laterally at the container and parts of which are disposed above the container and above the treatment fluid, and a vapour extraction device (17 to 22) for sucking away vapours in the region (10) in which parts of the lifting device (8) are disposed above the treatment fluid, **characterised in that** a plate (17), which has an opening (18) for a suction channel (19) of the vapour extraction device (17 to 22), is provided above the treatment fluid.

2. Device according to claim 1, **characterised in that** the lifting device (8) and the parts thereof disposed above the treatment fluid are enclosed by a housing which surrounds the region (10) for the vapour extraction device (17 to 22).

3. Device according to one of the preceding claims, **characterised by** a separating element (22) which separates the region (10) above the fluid surface from a surface region below which the substrate treatment takes place.

4. Device according to claim 3, **characterised in that** the separating element (22) is a vertical web which projects downwardly from the plate (17) provided in the region (10) and dips into the treatment fluid.

## Revendications

1. Dispositif pour le traitement de substrats (4) avec un récipient de fluide (1) contenant un fluide de traitement, avec au moins une installation de réception de substrats (3) et une installation de levage (8), prévue pour l'abaissement et le relevage de l'installation de réception de substrats, disposée latéralement au récipient et dont des parties se trouvent au-dessus du récipient et au-dessus du fluide de traitement, et avec une installation d'aspiration de vapeur (17 à 22) pour aspirer des vapeurs dans la zone (10) dans laquelle des parties de l'installation de levage (8) se trouvent au-dessus du fluide de traitement, **caractérisé en ce qu'**il est prévu dans la zone (10) au-dessus du fluide de traitement une plaque (17) qui présente une ouverture (18) pour un canal d'aspiration (19) de l'installation d'aspiration de vapeur (17 à 22).

2. Dispositif selon la revendication 1, **caractérisé en ce que** l'installation de levage (8) et ses parties se trouvant au-dessus du fluide de traitement sont entourées par un boîtier (9) qui entoure la zone (10) pour l'installation d'aspiration de vapeur (17 à 22).

3. Dispositif selon l'une des revendications précédentes, **caractérisé par** un élément séparateur (22) qui sépare la zone (10) au-dessus de la surface du fluide d'une zone de surface sous laquelle a lieu le traitement de substrats.

4. Dispositif selon la revendication 3, **caractérisé en ce que** l'élément séparateur (22) est une barrette verticale qui fait saillie de la plaque (17) prévue dans la zone (10) vers le bas et plonge dans le fluide de traitement.
